# EUROPÄISCHE PATENTANMELDUNG

(11) **EP 1 233 515 A2**
(43) Veröffentlichungstag der Anmeldung: **21.08.2002**
(21) Anmeldenummer: 01128943.6
(22) Anmeldetag: 06.12.2001
(51) Int. Cl.: H03K 17/96

(54) **Berührungssensor und Vorrichtung zum Schutz eines hervorstehenden Bauteils**

(30) Priorität: 14.02.2001 DE 10106699
(71) Anmelder: Leica Microsystems Wetzlar GmbH, 35578 Wetzlar (DE)
(72) Erfinder: Kaczynski, Ulrich, 61231 Bad Nauheim (DE)
(74) Vertreter: Reichert, Werner F., Dr.

(57) **Zusammenfassung**

Die Erfindung offenbart einen Berührungssensor (1) mit einem gegenüber einem ortsfesten Gehäuseteil (79) beabstandeten und beweglich angeordneten Anschlagelement (3) , einem Detektionssystem, das eine Lichtquelle (39) mit einer kleinen Emissionsfläche (23) und ein gegenüber der Emissionsfläche (23) der Lichtquelle (39) angeordnetes Empfangselement (25) beinhaltet, das eine Empfangsfläche (27) definiert, dadurch gekennzeichnet, dass die Empfangsfläche (27) und die Emissionsfläche (23) im Wesentlichen gleiche Größe aufweisen.

## Beschreibung

Die Erfindung betrifft einen Berührungssensor und eine Vorrichtung zum Schutz eines hervorstehenden Bauteils.

Vorrichtungen, die die Annäherung eines bewegten Bauteils an umgebende Bauteile detektieren, um eine bevorstehende Kollision, die die Bauteile beschädigen könnte, zu vermeiden sind weithin bekannt. Als aller einfachste Ausführung können Tastschalter verwendet werden, die in vielen Bauformen erhältlich sind.

Aus DE 42 34 375 ist eine Vorrichtung zur Personen- und Kollisionssicherung von fahrerlosen Gabelhubfahrzeugen bekannt, die zwischen den Zinkenspitzen der Hubgabel eine Lichtschranke aufweist.

Die Offenlegungsschrift DE 37 00 009 A1 offenbart eine optoelektronische Schutzzonenvorrichtung zur Sicherung von bewegten oder festen Objekten vor unsachgemäßer Berührung oder Kollision. Hierbei wird ein optoelektronischer Abstandssensor eingesetzt, der einen Lichtstrahl über einen einstellbaren Winkelbereich schwenkt. Durch Feststellen der Fleckgröße des Lichtstrahles auf umliegenden Objekten, wird auf den Abstand geschlossen und bei Unterschreiten eines Sicherheitsabstandes ein Signal ausgegeben.

Die Bekannten Vorrichtungen haben den Nachteil, dass sie zunächst nur relative Annäherungen aus einer Richtung erfassen können. Erst durch Schwenken der Anordnung oder durch den Einsatz mehrerer für verschiedene Richtungen ausgerichteter Vorrichtungen kann eine Annäherung aus verschiedenen Richtungen erfasst werden.

Insbesondere, wenn ein zusätzliches schwenken oder eine aufwendige Erfassung und Auswertung von Messwerten, wie beispielsweise die Bestimmung einer Lichtfleckgröße, erforderlich ist, kommt es zu Schaltverzögerungen, während denen sich die unerwünschte Annäherung fortsetzt.

Tastschalter können derart ausgestaltet sein, dass sie kurze Schaltwege aufweisen. Sie haben jedoch den bereits erwähnten Nachteil, dass sie nur Annäherungen aus einer Richtung erfassen. Ferner tragen Tastschalter baulich im Vergleich zum Schaltweg genau in dieser Richtung sehr stark auf. Insbesondere wenn für alle Raumrichtungen Tastschalter eingesetzt werden müssen, ist der Bewegungsfreiraum stark eingeschränkt oder muss zusätzlicher Raum vorgesehen sein.

In einer höchstgenauen Koordinaten-Messmaschine wird ein sehr schwerer, auf einem Luftlager gleitender, x/y-Messtisch aus Cerodur, der ein Objekt trägt, dessen Strukturen vermessen werden sollen, mit einer Genauigkeit von wenigen Nanometern verschoben. Mit einer solchen Messmaschine können zum Beispiel Strukturbreiten oder Strukturabstände einer Maske zur Waferbelichtung bestimmt werden. Die relative Position des x/y-Messtisches wird dabei interferometrisch gemessen. Oberhalb des Objektes ist ein Objektiv und unterhalb des Objektes ein Kondensor angeordnet. Das Objekt kann sowohl in Auflicht-, als auch in Durchlichtanordnung mikroskopisch untersucht werden. Zum Schutz von hervorstehenden Bauteilen insbesondere vor der Kollision mit dem schweren x/y-Messtisch, müssen Berührungssensoren implementiert werden.

Die Komponenten einer solchen höchstgenauen Koordinaten-Messmaschine sind aus sehr teurem und schwer zu bearbeitendem Material hergestellt. Die Komponenten, insbesondere der Messtisch, sollen daher nicht größer als nötig ausfallen. Auch mit Hinblick auf den teuren Reinraumplatz, auf dem solche Messmaschinen installiert werden, muss eine platzsparende Ausgestaltung gewählt werden. Der Einsatz von viel Bauraum in Anspruch nehmenden Berührungssensoren oder Tastschaltern ist vor diesem Hintergrund nachteilig.

Es ist daher Aufgabe der vorliegenden Erfindung, einen Berührungssensor anzugeben, bei dem die aufgezeigten Probleme zumindest weitgehend vermieden sind.

Obige Aufgabe wird gelöst durch einen Berührungssensor mit einem gegenüber einem ortsfesten Gehäuseteil beabstandeten und beweglich angeordneten Anschlagelement, einem Detektionssystem, das eine Lichtquelle mit einer Emissionsfläche und ein gegenüber der Emissionsfläche der Lichtquelle angeordnetes Empfangselement beinhaltet, das eine Empfangsfläche definiert, wobei die Empfangsfläche und die Emissionsfläche im Wesentlichen gleiche Größe aufweisen.

Es ist außerdem Aufgabe der vorliegenden Erfindung, eine Vorrichtung zum Schutz eines hervorstehenden Bauteils zu schaffen, die die beschriebenen Probleme vermeidet bzw. löst und darüber hinaus schnell arbeitet und zuverlässig ist.

Vorstehende Aufgabe wird gelöst durch eine Vorrichtung, die gekennzeichnet ist durch ein ortsfestes Gehäuseteil mit dem das hervorstehende Bauteil verbunden ist, ein gegenüber dem ortsfesten Gehäuseteil beabstandeten und beweglich angeordneten Anschlagelement, ein Detektionssystem, das eine Lichtquelle mit einer Emissionsfläche und ein gegenüber der Emissionsfläche der Lichtquelle angeordnetes Empfangselement beinhaltet, das eine Empfangsfläche definiert, wobei die Empfangsfläche und die Emissionsfläche im Wesentlichen gleiche Größe aufweisen.

Der erfindungsgemäße Berührungssensor hat den Vorteil, dass Berührungen aus verschiedenen Richtungen ohne großen apparativen Aufwand, wie Schwenken oder duplizieren des Sensors, detektiert werden.

Der Berührungssensor ist vorzugsweise derart ausgestaltet, dass schon bei sehr kleinen Verschiebungen des Anschlagelements der Lichtweg zwischen der Emissionsfläche und der Empfangsfläche unterbrochen wird. Hierzu sind die Emissionsfläche und die Empfangsfläche möglichst klein ausgeführt. Die Länge des Schaltweges liegt dann im Bereich des Durchmessers von Emissionsfläche bzw. Empfangsfläche. In einer ganz besonders bevorzugten Ausgestaltungsform ist die Emissionsfläche durch das Ende mindestens einer Lichtleitfaser definiert. Die Lichtleitfaser transportiert gleichzeitig das Licht der Lichtquelle. Auch die Verwendung eines Lichtleitfaserbündels ist möglich, wobei dann die Austrittsflächen der einzelnen Lichtleitfasern des Lichtleitfaserbündels die Emissionsfläche definieren.

In einer einfachen Ausführung des erfindungsgemäßen Berührungssensors ist der Empfangsfläche ein Intensitätssensor zugeordnet. Hierbei kann es sich beispielsweise um einen Halbleiterdetektor, eine Photodiode oder einen Photomultiplier handeln. Zwischen der Empfangsfläche und dem Intensitätssensor kann eine weitere Lichtleitfaser oder ein weiteres Lichtleitfaserbündel angeordnet sein. Die Lichtquelle kann beispielsweise ein Laser, eine Leuchtdiode oder eine Glühlampe sein. Bevorzugter Weise wird ein Halbleiterlaser verwendet.

In einer besonderen Ausgestaltungsform ist die Empfangsfläche eine Reflexionsfläche, die das von der Emissionsfläche ausgesendete Licht auf mindestens eine weitere Emissionsfläche richtet, die durch den Querschnitt einer Lichtleitfaser definiert ist. Diese Lichtleitfaser transportiert das Licht zu dem Intensitätssensor.

Das Anschlagelement kann auf verschiedene Arten beweglich mit dem Gehäuseteil verbunden sein. Vorzugsweise weist die Verbindung einen oder mehrere elastisch biegbare Stäbe auf. Der Stab ist bevorzugter Weise über eine Grundplatte mit dem Gehäuseteil verbunden, was die Montierbarkeit des Berührungssensors erleichtert.

Das Anschlagelement, die Grundplatte und deren Verbindung, beispielsweise der mindestens eine Stab, sowie das Empfangselement können zusammen einstückig gefertigt sein. In einer weiter bevorzugten Ausführungsform ist die Lichtquelle an der Grundplatte befestigt.

Vorzugsweise sind die Empfangsfläche und die Emissionsfläche unmittelbar übereinander angeordnet. Da das aus einem Lichtleitfaserende austretende Lichtbündel sehr divergent ist, ist es zur Vermeidung von Lichtverlusten vorteilhaft, den Berührungssensor so auszugestalten, dass der Lichtweg zwischen Empfangsfläche und Emissionsfläche kleiner als der Querschnitt der Emissionsfläche ist. Stattdessen kann jedoch auch zwischen Empfangsfläche und Emissionsfläche eine Optik angeordnet sein, die beispielsweise das von der Emissionsfläche ausgehende Licht auf die Empfangsfläche fokussiert.

Der Intensitätssensor erzeugt ein zur Leistung des auf die Emissionsfläche treffenden Lichtes proportionales elektrisches Signal. Dieses Signal kann zur Steuerung des Bewegungsablaufs dienen, der das Anschlagen am Anschlagelement und somit das elektrische Signal verursacht hat. Im einfachsten Fall wird die Bewegung gestoppt. Es ist auch eine Reduzierung der Bewegungsgeschwindigkeit steuer-, regel-, oder kontrollierbar.

Wenn die Emissionsfläche und die Empfangsfläche hinreichend groß ausgestaltet sind, kann eine geringe Verschiebung des Anschlagelements nur eine Teilweise Unterbrechung der Lichtweges zwischen der Emissionsfläche und der Empfangsfläche bewirken, was sich in einer Verringerung der Amplitude des elektrischen Signals äußert. Aus der Amplitudenänderung kann auf die Strecke geschlossen werden, die das Anschlagelement verschoben wurde.

In einer besonderen Ausführung der Vorrichtung zum Schutz eines hervorstehenden Bauteils umschließt das Anschlagelement das zu schützende Bauteil zumindest teilweise.

Ganz besonders vorteilhaft lässt sich die erfindungsgemäße Vorrichtung in einer hochpräzisen Messmaschine einsetzen. Da sich das Anschlagelement sehr platzsparend ausgestalten lässt, wird kein zusätzlicher Raum benötigt, was nicht zuletzt den Herstellungsaufwand und die Herstellungskosten der Messmaschine erheblich reduziert.

In einer speziellen Ausführung umschließt das Anschlagelement den Kondensor einer hochpräzisen Messmaschine und schützt durch Ausgabe eines den Bewegungsvorgang stoppenden Signals den Kondensor vor der Kollision mit dem schweren x/y-Messtisch.

In der Zeichnung ist der Erfindungsgegenstand schematisch dargestellt und wird anhand der Figuren nachfolgend beschrieben. Dabei zeigen:
- Fig. 1:: eine Ausführungsform des Berührungssensors in einer dreidimensionalen, perspektivischen Ansicht,
- Fig. 2:: den Berührungssensor aus Fig. 1 in der Draufsicht,
- Fig. 3:: den Berührungssensor aus Fig. 1 in der Seitenansicht,
- Fig. 4:: den Berührungssensor aus Fig. 1 in der Seitenansicht bei der Kollision mit einem Bauteil,
- Fig. 5:: das Detektionssystem des Berührungssensors und
- Fig. 6:: eine hochpräzise Messmaschine mit einer Vorrichtung zum Schutz des Kondensors.

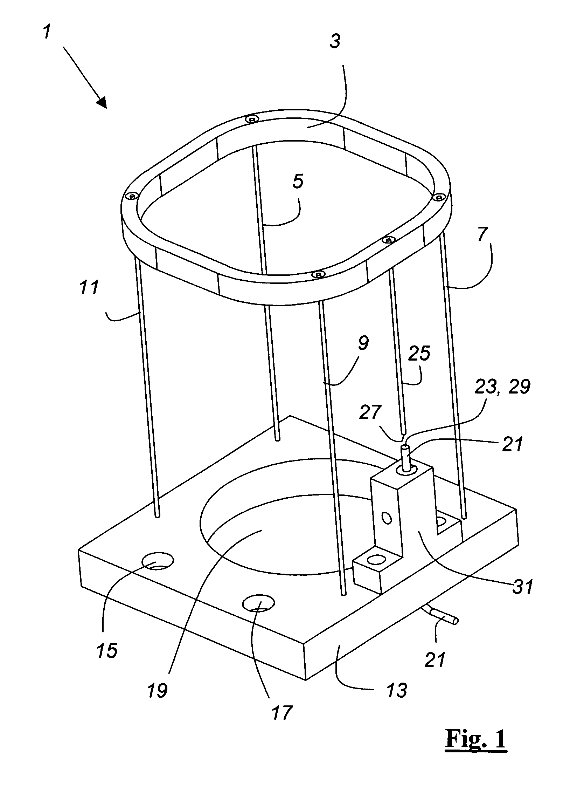

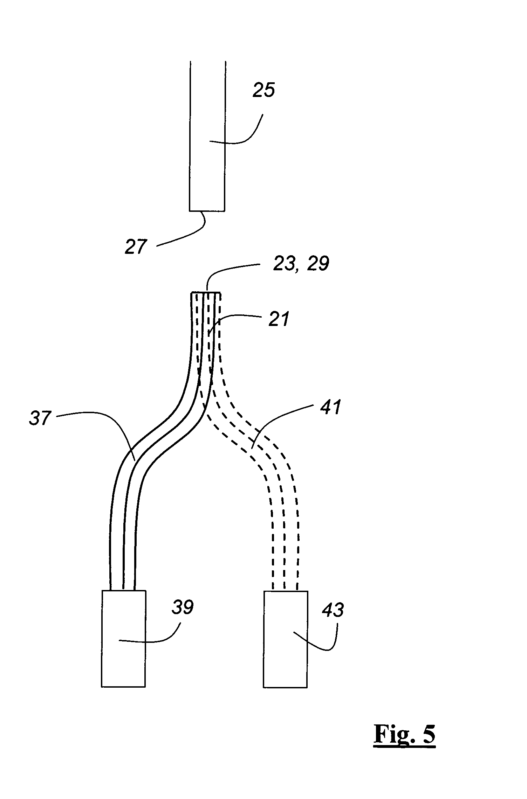

Fig. 1 zeigt einen erfindungsgemäßen Berührungssensor 1. Das Anschlagelement 3 ist über vier biegsame Stahlstäbe 5, 7, 9, 11 beweglich mit einer Grundplatte 13 verbunden. Die Grundplatte 13 weist eine erste Bohrung 15 und eine zweite Bohrung 17 zur Befestigung auf einem in dieser Figur nicht gezeigten Gehäuseteil, so wie eine Aussparung 19 auf, die gemeinsam mit dem Anschlagelement 3 einen Raum umschließt in den ein hervorstehendes Bauteil eingebracht wird. Durch die Grundplatte 13 hindurch ist ein Lichtleitfaserbündel 21 geführt. Eine erste Hälfte der Lichtleitfasern des Lichtleitfaserbündels 21 transportiert das Licht einer hier nicht gezeigten Lichtquelle zu der Emissionsfläche 23, die durch die Endflächen der ersten Hälfte der Lichtleitfasern des Lichtleitfaserbündels gebildet ist. Als Empfangselement 25 dient ein weiterer Stahlstab, dessen reflektierende Endfläche eine erste Empfangsfläche 27 bildet. Die Empfangsfläche 27 ist gegenüber der Emissionsfläche 23 angeordnet. Die Endflächen der zweiten Hälfte der Lichtleitfasern des Lichtleitfaserbündels bildet eine weitere Empfangsfläche 29. Das von der Emissionsfläche 23 ausgehende Licht gelangt demnach zunächst zur ersten Empfangsfläche 27 und wird dort zur weiteren Empfangsfläche 29 reflektiert. Durch die zweite Hälfte der Lichtleitfasern des Lichtleitfaserbündels 21 wird das Licht zu einem hier nicht gezeigten Intensitätssensor geführt. Der Verlauf der ersten und zweiten Hälfte der Lichtleitfasern des Lichtleitfaserbündels 21 ist in Fig. 5 dargestellt. Zur Fixierung des Lichtfaserbündels 21 ist ein Halteblock 31 installiert durch den das Lichtfaserbündel 21 verläuft und in dem es verklebt ist.

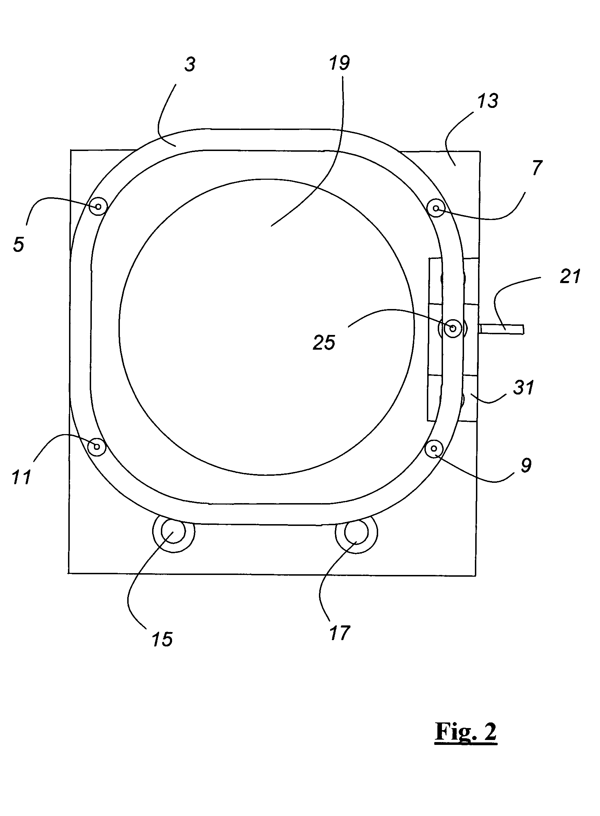

Fig. 2 zeigt den Berührungssensor 1 in der Draufsicht. Die Stahlstäbe 5, 7, 9, 11 und das Empfangselement 25 sind in das Anschlagelement 3 eingelötet.

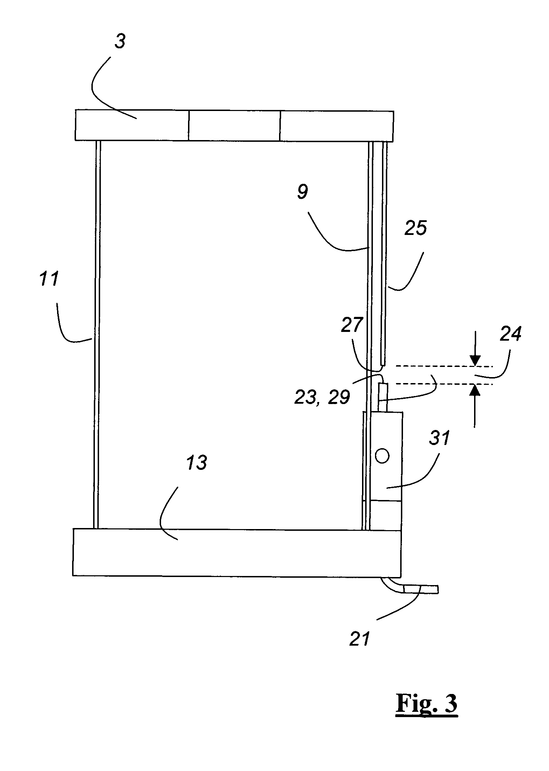

Fig. 3 zeigt den Berührungssensor 1 in einer Seitenansicht. Im Ausgangszustand Steht die Empfangsfläche 27 gegenüber der Emissionsfläche 23.

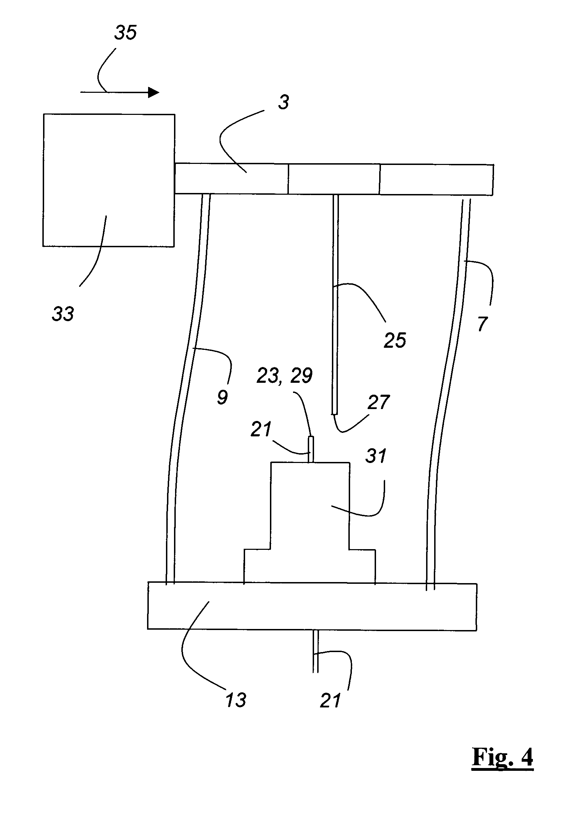

Fig. 4 zeigt den Berührungssensor 1 in einer Seitenansicht bei der Kollision mit einem Bauteil 33, das sich aus der mit dem Richtungspfeil 35 angedeuteten Richtung auf das Anschlagelement 3 des Berührungssensors 1 zu bewegt. Durch die Verschiebung des Anschlagelements 3 wird auch das Empfangselement 25 mit der Empfangsfläche 27 seitlich aus der Ausgangsposition verschoben, so dass es nicht mehr gegenüber der Emissionsfläche steht und somit kein Licht mehr reflektiert wird. Dementsprechend gelangt kein Licht zu der weiteren Empfangsfläche 29 und somit auch nicht zum Intensitätssensor. Die Veränderung der gemessenen Intensität detektiert und führt über eine hier nicht gezeigte elektronische Schaltung zum Stoppen des Bewegungsvorganges des Bauteils 33.

Fig. 5 zeigt das Detektionssystem des erfindungsgemäßen Berührungssensors. Eine erste Hälfte der Lichtleitfasern 37 des Lichtleitfaserbündels 21 transportiert das Licht einer Lichtquelle 39 zu der Emissionsfläche 23, die durch die Endflächen der ersten Hälfte der Lichtleitfasern 37 des Lichtleitfaserbündels 21 gebildet wird. Als Empfangselement 25 dient der Stahlstab 25, dessen reflektierende Endfläche die erste Empfangsfläche 27 bildet. Die erste Empfangsfläche 27 ist gegenüber der Emissionsfläche 23 angeordnet. Die Endflächen der zweiten Hälfte der Lichtleitfasern 41 des Lichtleitfaserbündels 21 bilden eine weitere Empfangsfläche 29. Das von der Emissionsfläche 23 ausgehende Licht gelangt demnach zunächst zur ersten Empfangsfläche 27 und wird dort zur weiteren Empfangsfläche 29 reflektiert. Durch die zweite Hälfte der Lichtleitfasern 41 des Lichtleitfaserbündels 21 wird das Licht zu einem Intensitätssensor 43 geführt. Das Glasfaserbündel 21 ist im Bereich der Emissions- und Empfangsfläche 23, 29 in einem Bündel geführt und teilt sich in einigem Abstand in die ersten und zweite Hälfte 37, 41 des Lichtleitfaserbündels 21 auf. Der Intensitätssensor ist als Photodiode ausgeführt, die ein elektrisches zur Leistung des auftreffenden Lichtes proportionales Signal erzeugt, das elektronisch weiterverarbeitet wird. Die Lichtquelle besteht in diesem Ausführungsbeispiel aus einem Diodenlaser.

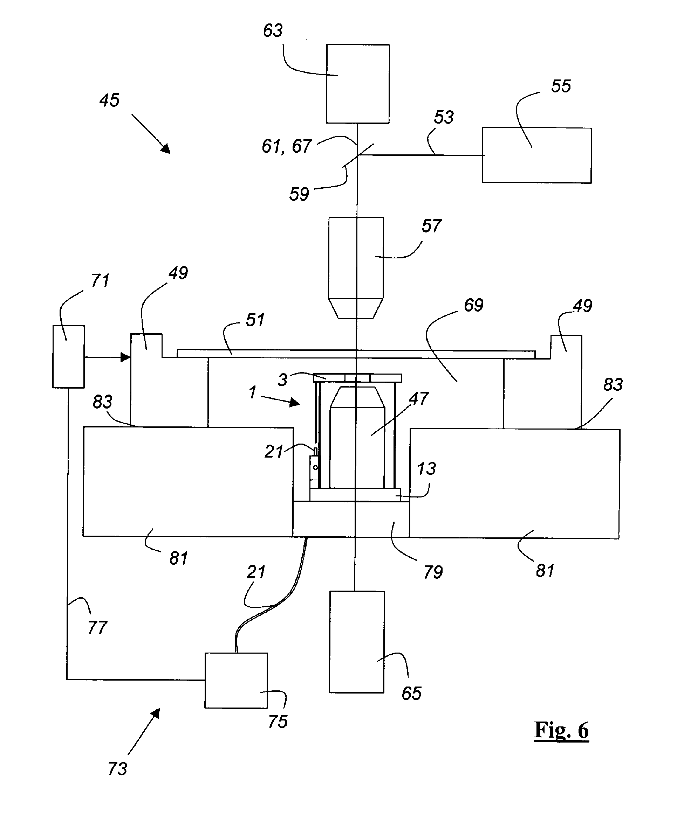

Fig. 6 zeigt eine hochpräzise Messmaschine 45 mit einer Vorrichtung zum Schutz eines Kondensors 47. In der höchstgenauen Koordinaten-Messmaschine 45 wird ein sehr schwerer, auf einem Luftlager gleitender, x/y-Messtisch 49 der aus Cerodur gefertigt ist und der ein Objekt 51 trägt, dessen Strukturen vermessen werden soll, mit einer Genauigkeit von wenigen Nanometern relativ zu einer Mikroskopoptik verschoben. Die relative Position des x/y-Messtisches 49 wird dabei interferometrisch gemessen. Das Objekt 51 kann sowohl in Auflicht-, als auch in Durchlichtanordnung mikroskopisch untersucht werden. Bei der Auflichtuntersuchung wird das Objekt 51 mit dem Licht 53 einer ersten Lichtquelle 55 durch ein Mikroskopobjektiv 57 hindurch beleuchtet. Zwischen der ersten Lichtquelle 55 und dem Mikroskopobjektiv 57 ist ein Strahlteiler 59 angeordnet, der das von der ersten Lichtquelle 55 kommende Licht 53 zum Mikroskopobjektiv reflektiert und das vom Objekt 51 ausgehende Licht 61 passieren lässt, so dass dieses zu einem Detektor 63 gelangt, der als Photomultiplier ausgeführt ist. Durch Verschieben des x/y-Messtisches wird das Objekt 51 abgerastert. In Durchlichtanordnung wird das Objekt 51 von einer zweiten Lichtquelle 65 durch den Kondensor 47 hindurch von unten beleuchtet. Das Durchlicht 67 wird im Detektor 63 detektiert.

Der x/y-Messtisch 49 weist im Innenbereich eine Aussparung 69 auf, innerhalb der der Kondensor 47 nahe an das am Rand aufliegende Objekt 51 geführt werden kann. Der Kondensor ist auf einem Gehäuseteil 79 befestigt. Der x/y-Messtisch wird von einem Elektromotor 71 angetrieben und gleitet auf einem Luftlager 83, das zwischen dem x/y-Messtisch und einem planpolierten Granittisch 81 aufgebaut ist. Da der Verfahrbereich des x/y-Messtisches größer ist, als die Aussparung 69 im Innenbereich, könnte es zu Kollisionen zwischen dem Kondensor 47 und dem x/y-Messtisch kommen. Zur Vermeidung einer Kollision ist eine Vorrichtung zum Schutz 73 des Kondensors 47 vorgesehen, die einen Berührungssensor 1 beinhaltet. Durch die Kompakte Bauweise des Berührungssensors 1, insbesondere des Anschlagelements 3 wird die Bewegungsfreiheit des x/y-Messtisches allenfalls unwesentlich eingeschränkt. Der Berührungssensor entspricht in seinem Aufbau dem in Fig. 1 bis Fig. 5 illustrierten Aufbau. Die Vorrichtung zum Schutz 73 des Kondensors 47, die über eine Grundplatte 13 an dem Gehäuseteil 79 befestigt ist, beinhaltet eine Steuereinheit 75, in der eine Lichtquelle 39 und ein Intensitätssensor implementiert sind. Das Licht der Lichtquelle gelangt wie bereits beschrieben über die erste Hälfte der Lichtleitfasern 37 des Lichtleitfaserbündels 21zur Emissionsfläche 23. Das von der Empfangsfläche 27, 29 ausgehende Licht gelangt über die zweite Hälfte der Lichtleitfasern 41 der Lichtleitfaserbündels 21 zur Steuereinheit 75 und darin zum Intensitätssensor 43. Bei einer Verringerung des Intensitätssignals wird über die Leitung 77 ein Signal zum Stoppen an den Elektromotor 71 geleitet.

Die Erfindung wurde in Bezug auf eine besondere Ausführungsform beschrieben. Es ist jedoch selbstverständlich, dass Änderungen und Abwandlungen durchgeführt werden können, ohne dabei den Schutzbereich der nachstehenden Ansprüche zu verlassen.

### Bezugszeichenliste:

- 1: Berührungssensor
- 3: Anschlagelement
- 5: Stahlstab
- 7: Stahlstab
- 9: Stahlstab
- 11: Stahlstab
- 13: Grundplatte
- 15: erste Bohrung
- 17: zweite Bohrung
- 19: Aussparung
- 21: Lichtleitfaserbündel
- 23: Emissionsfläche
- 24: Abstand
- 25: Empfangselement
- 27: Empfangsfläche
- 29: weitere Empfangsfläche
- 31: Halteblock
- 33: Bauteil
- 35: Richtungspfeil
- 37: erste Hälfte der Lichtleitfasern
- 39: Lichtquelle
- 41: zweite Hälfte der Lichtleitfasern
- 43: Intensitätssensor
- 45: Messmaschine
- 47: Kondensor
- 49: x/y-Messtisch
- 51: Objekt
- 53: Licht der ersten Lichtquelle
- 55: erste Lichtquelle
- 57: Mikroskopobjektiv
- 59: Strahlteiler
- 61: ausgehendes Licht
- 63: Detektor
- 65: zweite Lichtquelle
- 67: Durchlicht
- 69: Aussparung
- 71: Elektromotor
- 73: Vorrichtung zum Schutz
- 75: Steuereinheit
- 77: Leitung
- 79: Gehäuseteil
- 81: Granittisch
- 83: Luftlager

## Patentansprüche

1. Berührungssensor (1) mit einem gegenüber einem ortsfesten Gehäuseteil (79) beabstandeten und beweglich angeordneten Anschlagelement (3), einem Detektionssystem, das eine Lichtquelle (39) mit einer Emissionsfläche (23) und ein gegenüber der Emissionsfläche (23) der Lichtquelle (39) angeordnetes Empfangselement (25) beinhaltet, das eine Empfangsfläche (27) definiert, wobei die Empfangsfläche (27) und die Emissionsfläche (23) im Wesentlichen gleiche Größe aufweisen.

2. Berührungssensor (1) nach Anspruch 1, **dadurch gekennzeichnet, dass** die Emissionsfläche (23) durch das Ende mindestens einer Lichtleitfaser definiert ist.

3. Berührungssensor (1) nach Anspruch 1, **dadurch gekennzeichnet, dass** der Empfangsfläche (27) ein Intensitätssensor (43) zugeordnet ist.

4. Berührungssensor (1) nach Anspruch 1, **dadurch gekennzeichnet, dass** die Empfangsfläche (27) eine Reflexionsfläche ist, die das von der Emissionsfläche (23) ausgesendete Licht auf mindestens eine weitere, mit einem Intensitätssensor (43) verbundene, Lichtleitfaser richtet, deren Ende eine weitere Empfangsfläche (29) definiert.

5. Berührungssensor (1) nach einem der Ansprüche 1 bis 3, **dadurch gekennzeichnet, dass** das Anschlagelement (3) über mindestens einen elastisch biegbaren Stab (5, 7, 9, 11) beweglich mit dem Gehäuseteil (79) verbunden ist.

6. Berührungssensor (1) nach Anspruch 5, **dadurch gekennzeichnet, dass** das Anschlagelement (3), die Grundplatte (13), der mindestens eine Stab (5, 7, 9, 11) und das Empfangselement (25) zusammen einstückig gefertigt sind.

7. Berührungssensor (1) nach einem der Ansprüche 3 oder 4, **dadurch gekennzeichnet, dass** der Intensitätssensor (43) ein zur Leistung des auf die Emissionsfläche (23) treffenden Lichtes proportionales elektrisches Signal erzeugt.

8. Berührungssensor (1) nach Anspruch 12, **dadurch gekennzeichnet, dass** das elektrische Signal zur Steuerung eines Bewegungsvorganges dient.

9. Vorrichtung zum Schutz eines hervorstehenden Bauteils, **gekennzeichnet durch** ein ortsfestes Gehäuseteil (79) mit dem das hervorstehende Bauteil verbunden ist, ein gegenüber dem ortsfesten Gehäuseteil (79) beabstandeten und beweglich angeordneten Anschlagelement (3), ein Detektionssystem, das eine Lichtquelle (39) mit einer kleinen Emissionsfläche (23) und ein gegenüber der Emissionsfläche (23) der Lichtquelle (39) angeordnetes Empfangselement (25) beinhaltet, das eine Empfangsfläche (27) definiert, **dadurch gekennzeichnet**, dass die Empfangsfläche (27) und die Emissionsfläche (23) im Wesentlichen gleiche Größe aufweisen.

10. Vorrichtung nach Anspruch 9, **dadurch gekennzeichnet, dass** das Anschlagelement (3) das zu schützende Bauteil zumindest teilweise umschließt.

11. Vorrichtung nach Anspruch 9, **dadurch gekennzeichnet, dass** die Emissionsfläche (23) durch das Ende mindestens einer Lichtleitfaser definiert ist.

12. Vorrichtung nach Anspruch 9, **dadurch gekennzeichnet, dass** der Empfangsfläche (27) ein Intensitätssensor (43) zugeordnet ist.

13. Vorrichtung nach Anspruch 9, **dadurch gekennzeichnet, dass** die Empfangsfläche (27) eine Reflexionsfläche ist, die das von der Emissionsfläche (23) ausgesendete Licht auf mindestens eine weitere, mit einem Intensitätssensor (43) verbundene, Lichtleitfaser richtet, deren Ende eine weitere Empfangsfläche (29) definiert.

14. Vorrichtung nach einem der Ansprüche 12 oder 13, **dadurch gekennzeichnet, dass** der Intensitätssensor (43) ein zur Leistung des auf die Emissionsfläche (23) treffenden Lichtes proportionales elektrisches Signal erzeugt, das zur Steuerung, Kontrolle oder Regelung eines Bewegungsvorganges dient.

15. Vorrichtung nach Anspruch 14, **dadurch gekennzeichnet, dass** das Gehäuseteil (79) Bestandteil einer hochpräzisen Meßmaschine (45) ist.
